# EUROPEAN PATENT APPLICATION

(11) **EP 3 351 950 A1**
(43) Date of publication of application: **25.07.2018**
(21) Application number: 17208912.0
(22) Date of filing: 20.12.2017
(51) Int. Cl.: G01R 31/02

(54) **WIRE-CABLE SNAPPING SYMPTOM DETECTION APPARATUS**

(30) Priority: 19.01.2017 JP 2017007831
(71) Applicant: TOYOTA JIDOSHA KABUSHIKI KAISHA, Toyota-shi, Aichi, 471-8571 (JP)
(72) Inventor: YAMAMOTO, Kenichi, Toyota-shi, Aichi 471-8571 (JP)
(74) Representative: TBK

(57) **Abstract**

Detection means generates a first data group including a plurality of one-cycle time-series data in a reference period and a second data group including a predetermined number of one-cycle time-series data in an inspection target period, generates, after performing an offset correction for each one-cycle time-series data included in the first and second data groups, a first synchronized data group by sorting out data in the plurality of one-cycle time-series data included in the first data group according to the timing, generates a second synchronized data group by sorting out data in the plurality of one-cycle time-series data included in the second data group according to the timing, and detects a snapping symptom when a largest one of statistical differences between the first and second synchronized data groups at respective timings in the one cycle is larger than a predetermined threshold.

## Description

### BACKGROUND

The present disclosure relates to a wire-cable snapping symptom detection apparatus.

A technique for detecting a symptom of a snapping (hereinafter referred to as a "snapping symptom") of a wire cable that is repeatedly and cyclically bent and expanded has been proposed. For example, Japanese Unexamined Patent Application Publication No. 2007-139488 discloses a technique for detecting a snapping symptom of a wire cable which is repeatedly and cyclically bent and expanded and through which an electric current is being carried based on a relation between a cycle of the bending and extending of the wire cable and a cycle of changes in an electric state of the wire cable.

### SUMMARY

The present inventors have found the following problem. When some of wires constituting a wire cable which is repeatedly and cyclically bent and expanded and through which an electric current is being carried are broken, a resistance value between both ends of the wire cable cyclically changes according to the cycle of bending and expanding of the wire cable. In general, the resistance value between both ends of the wire cable in the bending state is larger than that in the expanding state. This is because when the wire cable is in the bending state, halves of broken wires are brought into contact with the other halves of the wires, whereas when the wire cable is in the expanding state, halves of broken wires are detached from the counterpart halves of the broken wires. As a result, when a difference between the resistance value between both ends of the wire cable in a state where no wire is broken and the resistance value in a state where some of the wires are broken exceeds a predetermined threshold at a certain timing in one cycle of bending and expanding of the wire cable, it is determined that there is a correlation between changes in the resistance value between both ends of the wire cable and the cycle of the bending and expanding of the wire cable. By doing so, it is possible to detect a snapping symptom of the wire cable.

When the wire cable is relatively long, the difference between the resistance value between both ends of the wire cable in the state where no wire is broken and the resistance value in the state where some of the wires are broken at the same timing in one cycle of bending and expanding is small, compared to when the wire cable is relatively short. Further, in general, the smaller the number of broken wires is, the smaller the difference between the resistance value between both ends of the wire cable in the state where no wire is broken and the resistance value in the state where some of the wires are broken at the same timing in one cycle of bending and expanding becomes. Therefore, in order to detect a snapping symptom of the wire cable even when the wire cable is long and/or the number of broken wires is small, it is necessary to set the above-described predetermined threshold to a small value.

It should be noted that the resistance value between both ends of a wire cable is affected by a disturbance that changes over a long period of time with respect to one cycle of bending and expanding of the wire cable such as variations in the ambient temperature and changes in the contact state between a terminal of a sensor and the wire cable with time. That is, when there is a disturbance that changes over a long period of time, the measured resistance value between both ends of the wire cable changes in a manner correlated with variations in the disturbance that change over a long period of time. Further, the resistance value between both ends of a wire cable detected by a sensor is affected by a sudden disturbance such as an abnormal overcurrent that instantaneously flows through the wire cable caused by lightning or the like. That is, when there is a sudden disturbance, the measured resistance value between both ends of the wire cable detected by the sensor sharply changes. In the case where there are such disturbances, there is a possibility that when the aforementioned predetermined threshold is set to a small value, a false determination that there is a snapping symptom of the wire cable may be made even though there is no snapping symptom in reality.

The present disclosure has been made in view of the above-described background and an object thereof is to provide a wire-cable snapping symptom detection apparatus capable of reducing an effect of a disturbance that changes over a long period of time with respect to one cycle of bending and expanding of the wire cable and an effect of a sudden disturbance and thereby detecting a snapping symptom of the wire cable more accurately.

A first exemplary aspect is a wire-cable snapping symptom detection apparatus including: a wire cable; a sensor configured to detect a resistance value in the wire cable through which a current is being carried; and detection means for detecting a snapping symptom of the wire cable based on the detected resistance value, in which the detection means: generates, for the wire cable which is repeatedly bent and expanded, a first data group by extracting a plurality of one-cycle time-series data each corresponding to one cycle of bending and expanding of the wire cable from time-series data detected in a reference period by the sensor; generates a second data group by extracting a predetermined number of one-cycle time-series data each corresponding to the one cycle of bending and expanding of the wire cable from time-series data detected in an inspection target period by the sensor, the inspection target period being later than the reference period; after performing a correction for each one-cycle time-series data included in the first and second data groups so that offsetting is performed and a first value of the one-cycle time-series data is thereby made equal to a predetermined value, generates a first synchronized data group by sorting out data in the plurality of one-cycle time-series data included in the first data group so that data obtained at the same timing in the one cycle are put together; generates a second synchronized data group by sorting out data in the plurality of one-cycle time-series data included in the second data group so that data obtained at the same timing in the one cycle are put together; obtains a statistical difference between the first and second synchronized data groups for respective data obtained at the same timing in the one cycle; and detects a snapping symptom of the wire cable when a largest one of the statistical differences obtained for the respective data obtained at the same timing in the one cycle is larger than a predetermined threshold.

A first data group is generated by extracting a plurality of one-cycle time-series data each corresponding to one cycle of bending and expanding of a wire cable from time-series data detected in a reference period in which there is no broken wire in the wire cable by a sensor. In this way, it is possible to obtain a plurality of data on the resistance value of the wire cable corresponding to the one cycle of bending and expanding in the reference period. Further, a second data group is generated by extracting a predetermined number of one-cycle time-series data each corresponding to the one cycle of bending and expanding of the wire cable from time-series data detected in an inspection target period by the sensor. In this way, it is possible to obtain the predetermined number of data on the resistance value of the wire cable corresponding to the one cycle of bending and expanding in the inspection period. By performing a correction for each one-cycle time-series data included in the first and second data groups so that offsetting is performed and a first value of the one-cycle time-series data is thereby made equal to a predetermined value, it is possible to reduce variations among the one-cycle time-series data caused by a disturbance that changes over a long period of time with respect to the one cycle of bending and expanding of the wire cable such as variations in the ambient temperature and changes in the contact state between a terminal of the sensor and the wire cable with time. A plurality of resistance values are obtained for each timing in the one cycle in the reference period by generating a first synchronized data group by sorting out data in the plurality of one-cycle time-series data included in the first data group so that data obtained at the same timing in the one cycle are put together. A predetermined number of resistance values are obtained for each timing in the one cycle in the inspection target period by generating a second synchronized data group by sorting out data in the plurality of one-cycle time-series data included in the second data group so that data obtained at the same timing in the one cycle are put together. Then, a statistical difference between the first and second synchronized data groups is obtained for respective data obtained at the same timing in the one cycle. That is, for each and same timing in the one cycle, a statistical difference between a plurality of data obtained in the reference period and a predetermined number of data obtained in the inspection target period is obtained. By doing so, it is possible to reduce an effect of a sudden disturbance such as an abnormal overcurrent that instantaneously flows through the wire cable caused by lightning or the like. Then, a snapping symptom of the wire cable is detected when a largest one of the statistical differences obtained for the respective data obtained at the same timing in the one cycle is larger than a predetermined threshold. Since an effect of a disturbance that changes over a long period of time with respect to the one cycle of bending and expanding of the wire cable and an effect of a sudden disturbance can be reduced in the above-described statistical difference as described above, the above-described predetermined threshold can be set to a smaller value. As a result, it is possible to detect a snapping symptom of the wire cable more accurately.

Further, the detection means may obtain an approximate normal distribution curve for a distribution of the plurality of resistance values detected in the wire cable, which is not snapped and through which an electric current is being carried, by the sensor, and determine the threshold based on a standard deviation in the obtained normal distribution curve.

The smaller the number of broken wires in the wire cable is, the smaller the statistical difference between the first and second synchronized data groups, which are obtained for respective data obtained at the same timing in the one cycle, becomes. Therefore, in order to detect a snapping symptom of the wire cable even when the wire cable is long and/or the number of broken wires in the wire cable is small, it is necessary to reduce the predetermined threshold which is used to determine whether or not there is a snapping symptom of the wire cable. As described above, the effects of disturbances can be reduced in the statistical difference between the first and second synchronized data groups which are obtained for respective data obtained at the same timing in the one cycle. Therefore, it is possible to set the predetermined threshold, which is used to determine whether or not there is a snapping symptom of the wire cable, to a smaller value comparable to measurement errors, e.g., to a value six times the standard deviation of the normal distribution curve. As a result, it is possible to accurately detect a snapping symptom of the wire cable even when the wire cable is long and/or the number of broken wires in the wire cable is small.

Further, the statistical difference may be a difference between an average value of synchronized data at a certain timing in the one cycle included in the first synchronized data group and an average value of synchronized data at that timing included in the second synchronized data group.

By doing so, it is possible to reduce an effect of a disturbance that changes over a long period of time with respect to the one cycle of bending and expanding of the wire cable and an effect of a sudden disturbance and thereby detect a snapping symptom of the wire cable more accurately.

According to the present disclosure, it is possible to reduce an effect of a disturbance that changes over a long period of time with respect to the one cycle of bending and expanding of a wire cable and an effect of a sudden disturbance and thereby detect a snapping symptom of a wire cable more accurately.

The above and other objects, features and advantages of the present invention will become more fully understood from the detailed description given hereinbelow and the accompanying drawings which are given by way of illustration only, and thus are not to be considered as limiting the present invention.

### BRIEF DESCRIPTION OF DRAWINGS

Fig. 1 is a schematic view showing a rough configuration of a snapping symptom detection apparatus according to an embodiment;
Fig. 2 is a schematic view for explaining a bending state and an expanding state of a wire cable 5 in which some of the wires are broken;
Fig. 3 is a flowchart showing a flow of processes performed by detection means in the snapping symptom detection apparatus according to the embodiment;
Fig. 4 is a graph showing an example of time-series data detected in a reference period by a sensor;
Fig. 5 is a graph showing an example of a first data group generated by extracting a plurality of one-cycle time-series data each corresponding to one cycle of bending and expanding of a wire cable from time-series data detected in the reference period by the sensor;
Fig. 6 is a graph showing an example of time-series data detected in an inspection target period by the sensor;
Fig. 7 is a graph showing an example of a second data group generated by extracting a plurality of one-cycle time-series data each corresponding to the one cycle of bending and expanding of the wire cable from time-series data detected in the inspection target period by the sensor;
Fig. 8 is a graph showing time-series data obtained by performing a correction for the first data group shown in Fig. 5 so that offsetting is performed and a first value of the one-cycle time-series data is thereby made equal to a predetermined value;
Fig. 9 is a graph showing time-series data obtained by performing a correction for the second data group shown in Fig. 7 so that offsetting is performed and a first value of the one-cycle time-series data is thereby made equal to a predetermined value;
Fig. 10 is a graph showing a first synchronized data group generated by sorting out data in the plurality of one-cycle time-series data included in the first data group shown in Fig. 8, for which the offset correction has been performed, so that data obtained at the same timing in the one cycle are put together;
Fig. 11 is a graph showing a second synchronized data group generated by sorting out data in the plurality of one-cycle time-series data included in the second data group shown in Fig. 9, for which the offset correction has been performed, so that data obtained at the same timing in the one cycle are put together;
Fig. 12 is a graph obtained by plotting an average value of synchronized data at each timing in the one cycle included in the first synchronized data group and an average value of synchronized data at each timing in the one cycle included in the second synchronized data group;
Fig. 13 is a graph showing an example of a distribution of resistance values that are detected in advance in a wire cable that is not snapped and through which an electric current is being carried by the sensor; and
Fig. 14 is a graph showing a relation between the number of broken wires in a wire cable and the maximum value of the statistical difference between the first and second synchronized data groups which are obtained for respective data obtained at the same timing in the one cycle.

### DESCRIPTION OF EMBODIMENTS

Embodiments according to the present disclosure are explained hereinafter with reference to the drawings.

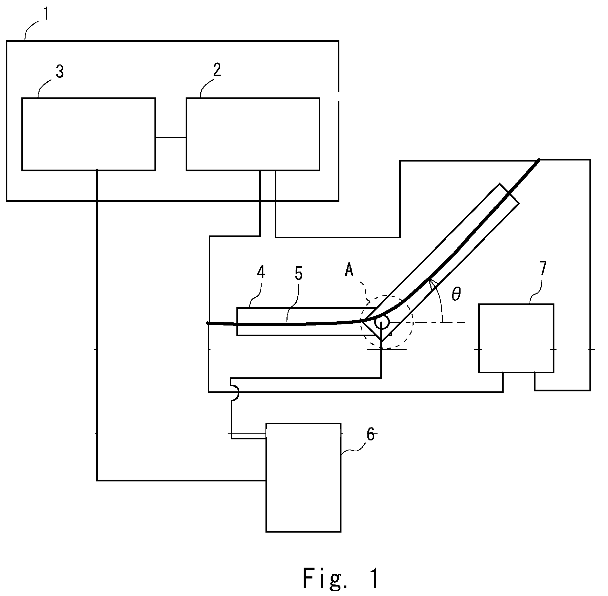

Firstly, a rough configuration of a wire-cable snapping symptom detection apparatus 1 according to this embodiment is explained with reference to Fig. 1. Note that the fact that there is a snapping symptom in a wire cable means that some of the wires in the wire cable are broken.

Fig. 1 is a schematic view showing a rough configuration of the wire-cable snapping symptom detection apparatus 1 according to this embodiment. As shown in Fig. 1, the snapping symptom detection apparatus 1 includes a sensor 2 and detection means 3.

A wire cable 5, regarding which the snapping symptom detection apparatus 1 detects a snapping symptom, is attached to a robot 4 that performs bending actions. The robot 4 is controlled by a control apparatus 6 so that it repeats bending and expanding actions. In this way, the wire cable 5 repeats bending and expanding actions. An electric current is being carried through the wire cable 5 by a power supply 7. The sensor 2 detects a resistance value between both ends of the current-carrying wire cable 5. The resistance value detected by the sensor 2 is stored in a recording medium provided in the detection means 3.

The detection means 3 is configured to detect a snapping symptom of the wire cable 5 based on the resistance value detected by the sensor 2. Detection data on the resistance value is transmitted from the sensor 2 to the detection means 3. Further, a signal indicating a cycle of bending and expanding actions is transmitted from the control apparatus 6 to the detection means 3. The signal indicating the cycle of bending and expanding actions transmitted from the control apparatus 6 is stored in the recording medium disposed in the detection means 3. Note that the signal indicating the cycle of bending and expanding actions is a signal indicating a phase (a bending angle θ) of the robot 4 for an elapsed period of time. Further, details of the process performed by the detection means 3 will be described later.

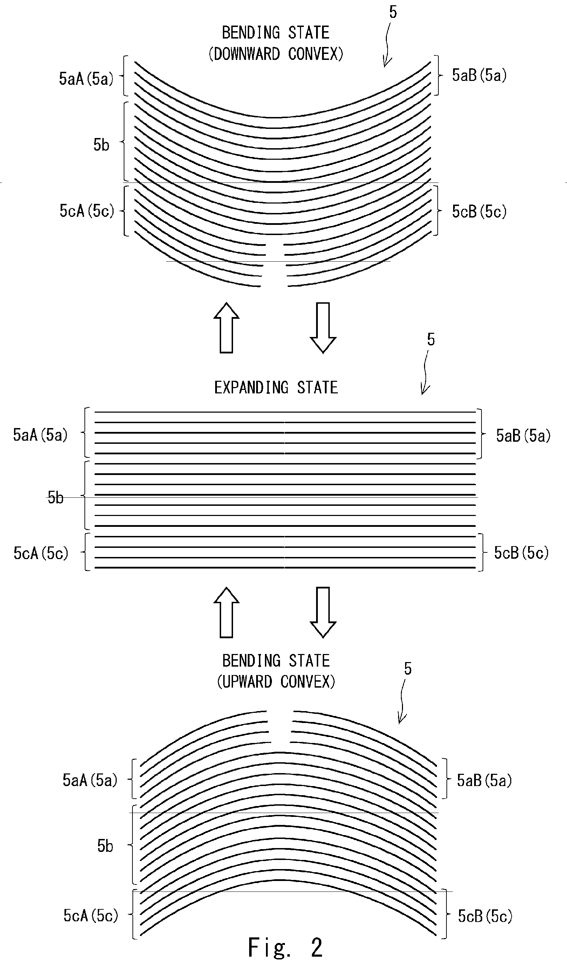

Fig. 2 is a schematic view for explaining a bending state and an expanding state of the wire cable 5 in which some of the wires are broken. Fig. 2 shows enlarged views of an area A enclosed by broken lines in Fig. 1 in various states of the wire cable 5. Note that wire groups 5a and 5c of the wire cable 5 are broken and a wire group 5b of the wire cable 5 is not broken. The wire group 5a includes halved-wire groups 5aA and 5aB. Similarly, the wire group 5c includes halved-wire groups 5cA and 5cB. As shown in Fig. 2, in a downward-convex bending state, the halved-wire groups 5cA and 5cB of the broken-wire group 5c of the wire cable 5 are detached from each other, while the halved-wire groups 5aA and 5aB of the broken-wire group 5a of the wire cable 5 are in contact with each other. In an expanding state, the halved-wire groups 5aA and 5aB of the broken-wire group 5a of the wire cable 5 are in contact with each other, and the halved-wire groups 5cA and 5cB of the broken-wire group 5c of the wire cable 5 are also in contact with each other. In an upward-convex bending state, the halved-wire groups 5aA and 5aB of the broken-wire group 5a of the wire cable 5 are detached from each other, while the halved-wire groups 5cA and 5cB of the broken-wire group 5c of the wire cable 5 are in contact with each other.

Among the broken wires, an electric current flows through wires in which halves of the wires are in contact with the counterpart halves of the wires, while no electric current flows through wires in which halves of the wires are detached from the counterpart halves of the wires. The ratio of broken wires in which halves of the wires are detached from the counterpart halves of the wires to all the broken wires in the bending state is higher than the ratio in the expanding state. Therefore, the resistance value of the wire cable 5 in the bending state is larger than the resistance value in the expanding state.

Next, a flow of processes performed by the detection means 3 of the snapping symptom detection apparatus 1 is explained. Note that the following explanation is given while referring to Fig. 1 as required.

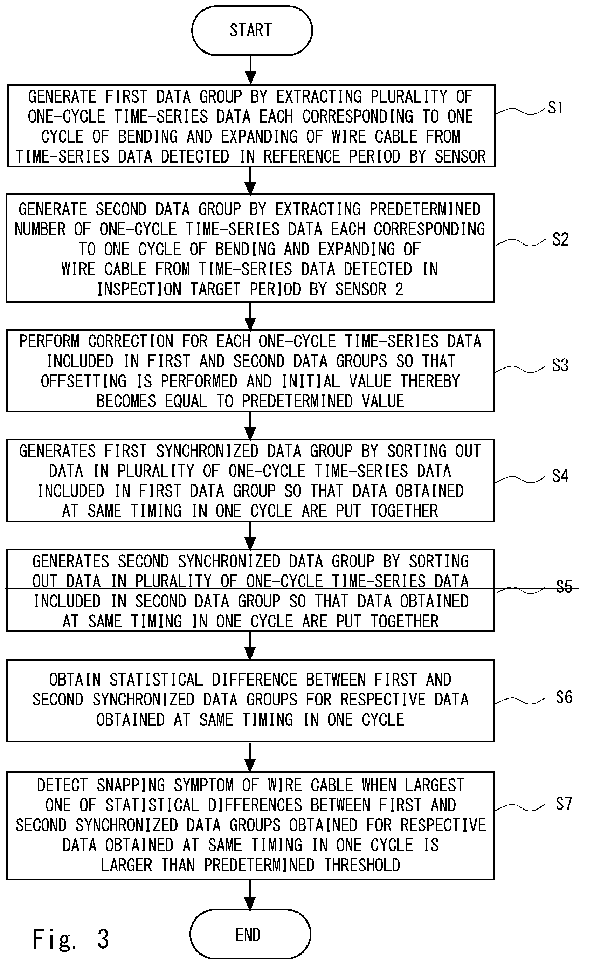

Fig. 3 is a flowchart showing a flow of processes performed by the detection means 3. As shown in Fig. 3, firstly, a first data group is generated by extracting a plurality of one-cycle time-series data each corresponding to one cycle of bending and expanding of the wire cable 5 from time-series data detected in a reference period by the sensor 2 (step S1). Note that the reference period is a period in which there is no snapping symptom in the wire cable 5. Next, a second data group is generated by extracting a predetermined number of one-cycle time-series data each corresponding to one cycle of bending and expanding of the wire cable 5 from time-series data detected in an inspection target period that is later than the reference period by the sensor 2 (step S2).

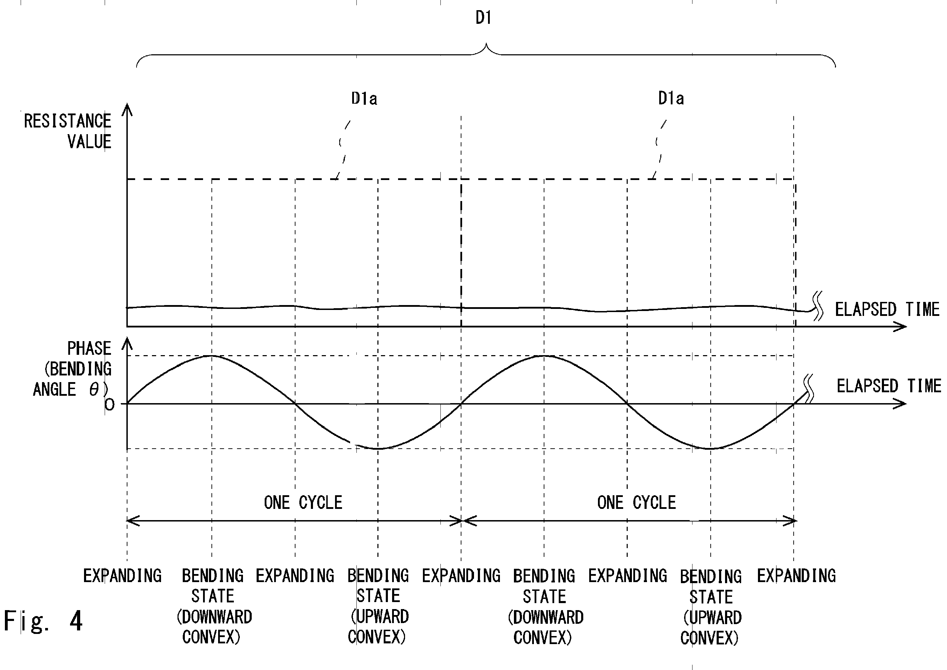

Fig. 4 is a graph showing an example of time-series data D1 detected in the reference period by the sensor 2. Note that a graph in the upper part shows the resistance value of the wire cable 5 detected by the sensor 2 over an elapsed period of time. In the graph in the upper part, the horizontal axis indicates the elapsed period of time and the vertical axis indicates the resistance value of the wire cable 5 detected by the sensor 2. A graph in the lower part shows phases (bending angles θ) over the elapsed period of time. In the graph in the lower part, the horizontal axis indicates the elapsed period of time and the vertical axis indicates the phase (the bending angle θ). It is defined that the phase (the bending angle θ) has a positive value when the wire cable 5 is in a downward-convex bending state and has a negative value when the wire cable 5 is in an upward-convex bending state as shown in Fig. 2. Note that Fig. 4 shows only a part of the whole time-series data D1.

As shown in Fig. 4, in one cycle of the phase (the bending angle θ) of the robot 4, the state of the wire cable 5 successively changes from an expanding state to a downward-convex bending state, an expanding state, an upward-convex bending state, and an expanding state. Since no wire is broken in the wire cable 5 in the reference period, the resistance value of the wire cable 5 hardly changes over the one cycle of the phase (the bending angle θ) of the robot 4.

The range enclosed by broken lines in the time-series data D1 is one-cycle time-series data D1a corresponding to one cycle of bending and expanding of the wire cable 5. In the step S1 in Fig. 3, a first data group is generated by extracting a plurality of one-cycle time-series data D1a each corresponding to one cycle of bending and expanding of the wire cable 5 from the time-series data D1 detected in the reference period by the sensor 2. That is, the first data group includes a plurality of data on the resistance value of the wire cable 5 (i.e., a plurality of one-cycle time-series data D1a) each corresponding to one cycle of bending and expanding in the reference period. Note that the number of one-cycle time-series data D1a included in the first data group is preferably as large as possible.

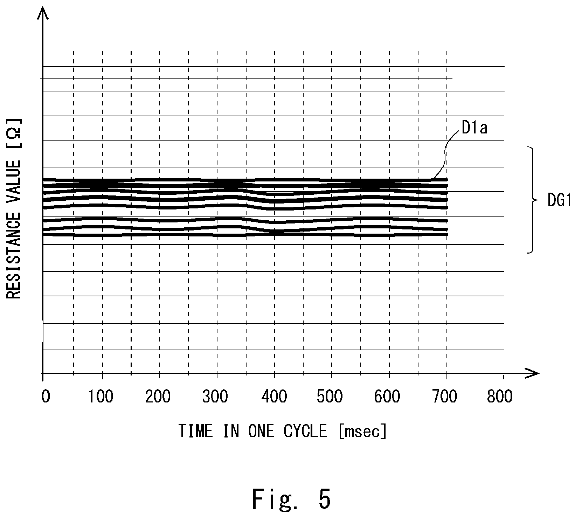

Fig. 5 is a graph showing an example of a first data group DG1 generated by extracting a plurality of one-cycle time-series data D1a each corresponding to one cycle of bending and expanding of the wire cable 5 from the time-series data D1 (see Fig. 4) detected in the reference period by the sensor 2. Note that the horizontal axis indicates the time [msec] in one cycle and the vertical axis indicates the resistance value of the wire cable 5 detected by the sensor 2. Each of the one-cycle time-series data D1a included in the first data group DG1 includes resistance values between both ends of the wire cable 5 corresponding to one cycle (700 msec) which are detected at intervals of 50 msec by the sensor 2. As shown in Fig. 5, in the first data group DG1, the plurality of one-cycle time-series data D1a varies in such a manner that data corresponding to one cycle included in each of the plurality of one-cycle time-series data shifts as a whole. The variations are caused by a disturbance that changes over a long period of time with respect to the one cycle of bending and expanding of the wire cable 5 such as variations in the ambient temperature and changes in the contact state between a terminal of the sensor 2 and the wire cable 5 with time.

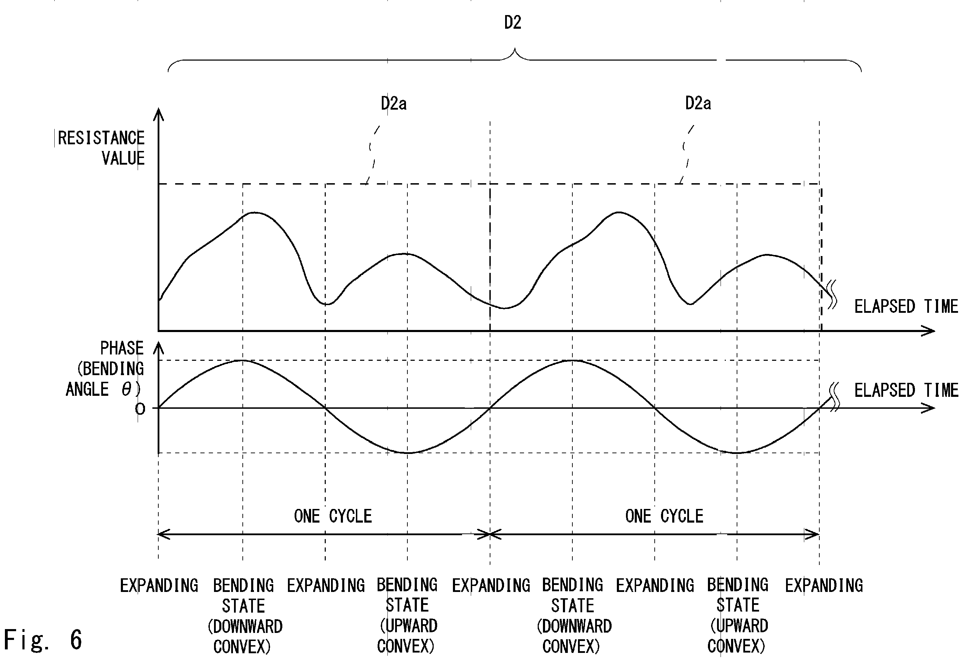

Fig. 6 is a graph showing an example of time-series data D2 detected in the inspection target period by the sensor 2. Similarly to Fig. 4, a graph in the upper part shows the resistance value over an elapsed period of time and a graph in the lower part shows the phase over the elapsed period of time. In the graph in the upper part, the horizontal axis indicates the elapsed period of time and the vertical axis indicates the resistance value of the wire cable 5 detected by the sensor 2. In the graph in the lower part, the horizontal axis indicates the elapsed period of time and the vertical axis indicates the phase (the bending angle θ). Note that Fig. 6 shows only a part of the whole time-series data D2.

As shown in Fig. 6, the resistance value of the wire cable 5 changes over one cycle of the phase (the bending angle θ) of the robot 4. This is because some of the wires of the wire cable 5 are broken. Further, the resistance value of the wire cable 5 in the bending state is larger than the resistance value in the expanding state. This is because, as explained above with reference to Fig. 2, the ratio of broken wires in which halves of the wires are detached from the counterpart halves of the wires to all the broken wires in the wire cable 5 in the downward convex bending state or in the upward convex bending state is higher than the ratio in the expanding state.

The range enclosed by broken lines in the time-series data D2 is one-cycle time-series data D2a corresponding to one cycle of bending and expanding of the wire cable 5. In the step S2 in Fig. 3, a second data group is generated by extracting a predetermined number n of one-cycle time-series data D2a each corresponding to one cycle of bending and expanding of the wire cable 5 from the time-series data D2 detected in the inspection target period by the sensor 2. That is, the second data group includes the predetermined number n of data on the resistance value of the wire cable (i.e., the predetermined number n of one-cycle time-series data D2a) each corresponding to one cycle of bending and expanding in the inspection target period. The predetermined number n is experimentally determined so that the accuracy of the detection of a snapping symptom of the wire cable 5 in the snapping symptom detection apparatus 1 becomes sufficiently high.

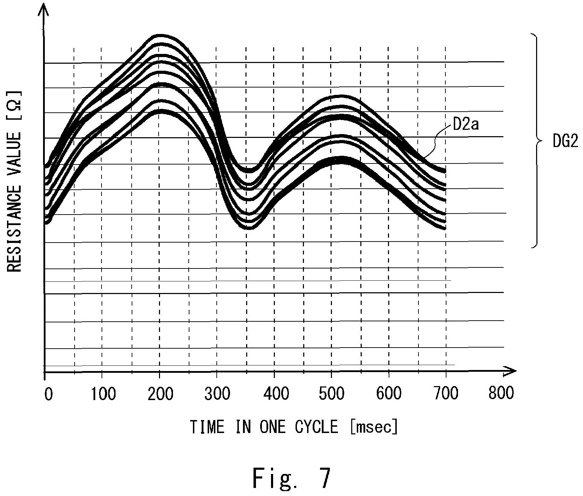

Fig. 7 is a graph showing an example of a second data group DG2 generated by extracting the predetermined number n of one-cycle time-series data D2a each corresponding to one cycle of bending and expanding of the wire cable 5 from the time-series data D2 (see Fig. 6) detected in the inspection target period by the sensor 2. Note that the horizontal axis indicates the time [msec] in one cycle and the vertical axis indicates the resistance value of the wire cable 5 detected by the sensor 2. Each of the one-cycle time-series data D2a included in the second data group DG2 includes resistance values between both ends of the wire cable 5 corresponding to one cycle (700 msec) which are detected at intervals of 50 msec by the sensor 2. As shown in Fig. 7, in the second data group DG2, the plurality of one-cycle time-series data D2a varies in such a manner that data corresponding to one cycle included in each of the plurality of one-cycle time-series data shifts as a whole. The variations are caused by a disturbance that changes over a long period of time with respect to the one cycle of bending and expanding of the wire cable 5 such as variations in the ambient temperature and changes in the contact state between the terminal of the sensor 2 and the wire cable 5 with time.

Referring to Fig. 3 again, subsequent to the step S2, a correction is performed for each one-cycle time-series data included in the first and second data groups so that offsetting is performed and a first value of the one-cycle time-series data is thereby made equal to a predetermined value (step S3).

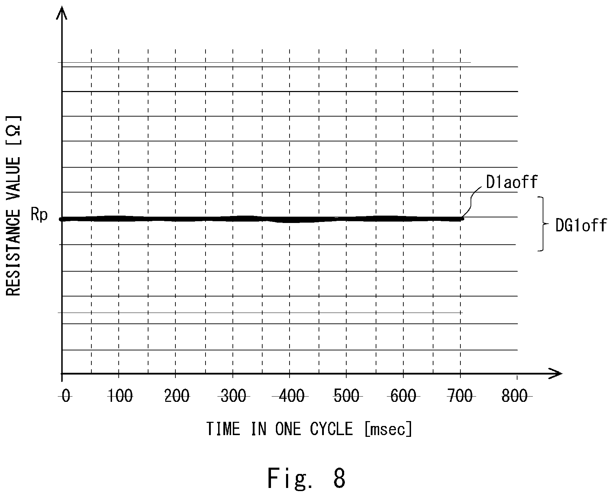

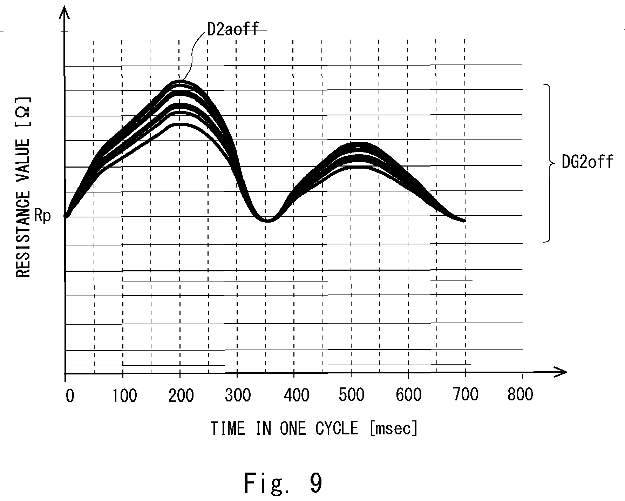

Fig. 8 is a graph showing a first data group DG1off that is obtained by performing the correction for the first data group DG1 shown in Fig. 5 so that offsetting is performed and the first value of each one-cycle time-series data is thereby made equal to a predetermined value. Note that the horizontal axis indicates the time [msec] in one cycle and the vertical axis indicates the resistance value (the resistance value after the offset correction) of the wire cable 5 detected by the sensor 2. As shown in Fig. 8, all of the one-cycle time-series data D1aoff included in the first data group DG1off are off-set (i.e., shifted or adjusted) so that their first values become equal to a predetermined value Rp. Fig. 9 is a graph showing a second data group DG2off that is obtained by performing the correction for the second data group DG2 shown in Fig. 7 so that offsetting is performed and the first value of each one-cycle time-series data is thereby made equal to a predetermined value. Note that the horizontal axis indicates the time [msec] in one cycle and the vertical axis indicates the resistance value (the resistance value after the offset correction) of the wire cable 5 detected by the sensor 2. As shown in Fig. 9, all of the one-cycle time-series data D2aoff included in the second data group DG2off are off-set (i.e., shifted or adjusted) so that their first values become equal to the predetermined value Rp. By performing an offset correction as described above, variations among one-cycle time-series data caused by a disturbance that changes over a long period of time with respect to the one cycle of bending and expanding of the wire cable 5 such as variations in the ambient temperature and changes in the contact state between the terminal of the sensor 2 and the wire cable 5 with time are reduced.

Referring to Fig. 3 again, subsequent to the step S3, a first synchronized data group is generated by sorting out data in the plurality of one-cycle time-series data included in the first data group so that data obtained at the same timing in the one cycle are put together (step S4). Similarly, a second synchronized data group is generated by sorting out data in the plurality of one-cycle time-series data included in the second data group so that data obtained at the same timing in the one cycle are put together (step S5).

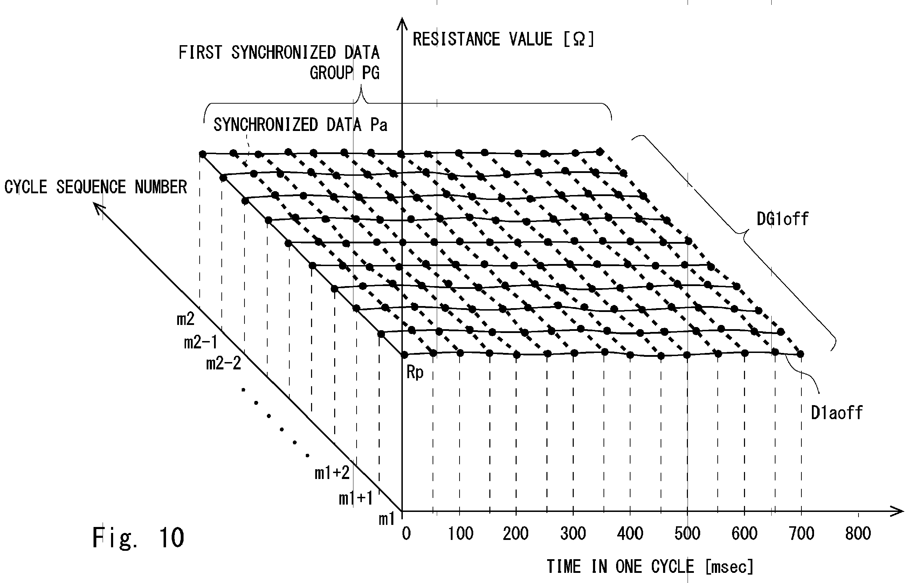

Fig. 10 is a graph showing a first synchronized data group PG generated by sorting out data in the plurality of one-cycle time-series data D1aoff included in the first data group DG1off shown in Fig. 8, for which the offset correction has been performed, so that data obtained at the same timing in the one cycle are put together. Note that one of the horizontal axes indicates the time [msec] in one cycle and the other horizontal axis indicates cycle sequence numbers. Further, the vertical axis indicates the resistance value (the resistance value after the offset correction) of the wire cable 5 detected by the sensor 2. The cycle sequence number indicates the sequence number of a given one-cycle time-series data counted from the start of the detection of the resistance value of the wire cable 5 by the sensor 2. The first data group DG1off includes a plurality of one-cycle time-series data D1aoff having cycle sequence numbers m1 to m2 (m1<m2). As shown in Fig. 10, the first synchronized data group PG includes synchronized data Pa that are obtained at 0 to 700 msec in one cycle at intervals of 50 msec. That is, the synchronized data group Pa including a plurality of resistance values is obtained for each timing in the one cycle in the reference period by generating the first synchronized data group PG by sorting out data in the plurality of one-cycle time-series data D1aoff included in the first data group DG1off, for which the offset correction has been performed, so that data obtained at the same timing in the one cycle are put together.

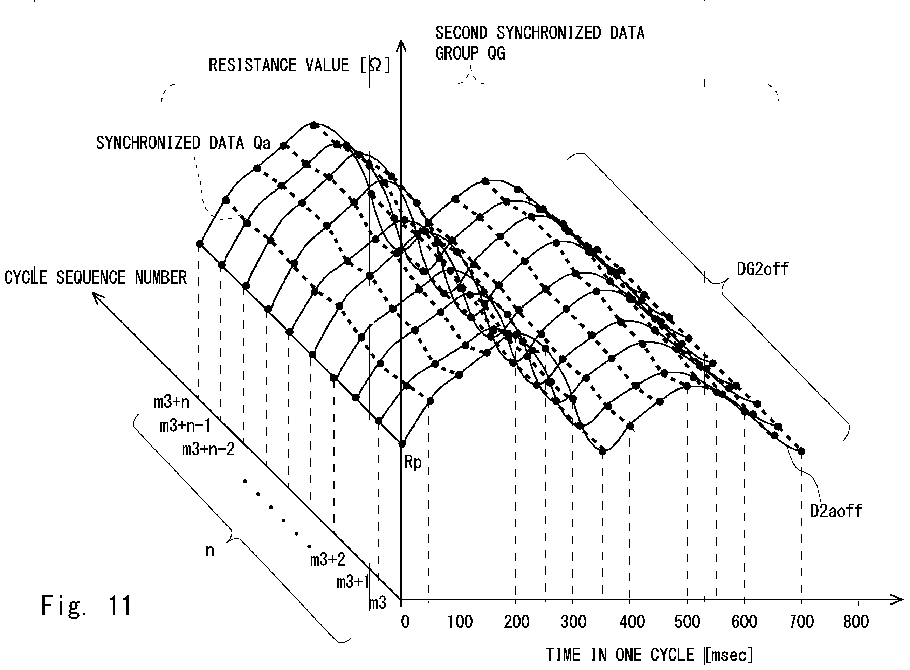

Fig. 11 is a graph showing a second synchronized data group QG generated by sorting out data in the plurality of one-cycle time-series data D2aoff included in the second data group DG2off shown in Fig. 9, for which the offset correction has been performed, so that data obtained at the same timing in the one cycle are put together. Note that one of the horizontal axes indicates the time [msec] in one cycle and the other horizontal axis indicates cycle sequence numbers. Further, the vertical axis indicates the resistance value (the resistance value after the offset correction) of the wire cable 5 detected by the sensor 2. The second data group DG2off includes the predetermined number n of one-cycle time-series data D2aoff having cycle sequence numbers m3 to m3+n. Further, the number m3 is larger than the number m2 (m3>m2) (see Fig. 10). As shown in Fig. 11, the second synchronized data group QG includes synchronized data Qa that are obtained at 0 to 700 msec in one cycle at intervals of 50 msec. That is, the synchronized data group Qa including the predetermined number of resistance values is obtained for each timing in the one cycle in the inspection target period by generating the second synchronized data group QG by sorting out data in the plurality of one-cycle time-series data D2aoff included in the second data group DG2off, for which the offset correction has been performed, so that data obtained at the same timing in the one cycle are put together.

Referring to Fig. 3 again, subsequent to the step S5, a statistical difference between the first and second synchronized data groups is obtained for respective data obtained at the same timing in the one cycle (step S6). The statistical difference between the first and second synchronized data groups is, for example, a difference between an average value of synchronized data at a certain timing in the one cycle included in the first synchronized data group and an average value of synchronized data at that timing included in the second synchronized data group. By obtaining, for each and same timing in the one cycle, a statistical difference between a plurality of resistance values obtained in the reference period and a predetermined number of resistance values obtained in the inspection target period, it is possible to reduce an effect of a sudden disturbance such as an abnormal overcurrent that instantaneously flows through the wire cable 5 caused by lightning or the like.

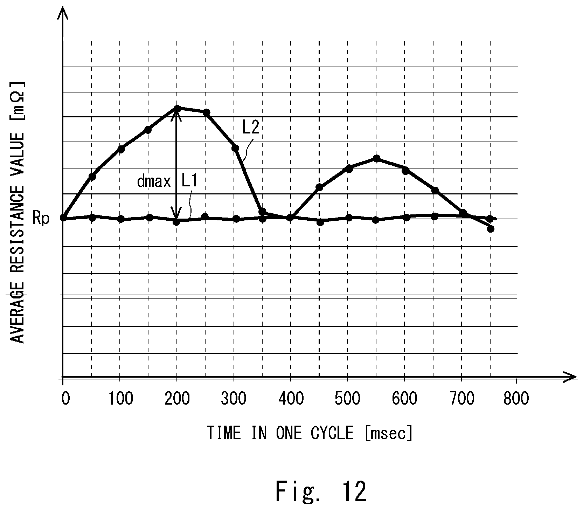

Fig. 12 is a graph obtained by plotting an average value of synchronized data at each timing in one cycle included in the first synchronized data group PG (see Fig. 10) and an average value of synchronized data at each timing in one cycle included in the second synchronized data group QG (see Fig. 11). Note that the horizontal axis indicates the time [msec] in one cycle and the vertical axis indicates average resistance values [mΩ] obtained by averaging resistance values included in the synchronized data. A line L1 is obtained by connecting plotted points of average values of synchronized data at each timing in one cycle included in the first synchronized data group PG. A line L2 is obtained by connecting plotted points of average values of synchronized data at each timing in one cycle included in the second synchronized data group QG. As shown in Fig. 12, the difference between the average value of the synchronized data at a certain timing in one cycle included in the first synchronized data group PG and the average value of the synchronized data at that timing included in the second synchronized data group QG is maximized (indicated by "dmax") at 200 msec in one cycle.

Note that the maximum value and the minimum value in the synchronized data may be excluded when the average value of the synchronized data at a certain timing in one cycle is obtained. Further, the difference between the average value of the synchronized data at a certain timing in one cycle included in the first synchronized data group PG and the average value of the synchronized data at that timing included in the second synchronized data group QG may be obtained by using a t-test. By doing so, it is possible to improve the accuracy of the detection of a snapping symptom.

The statistical difference between the first synchronized data group PG and the second synchronized data group QG is not limited to the difference between the average value of the synchronized data at a certain timing in one cycle included in the first synchronized data group PG and the average value of the synchronized data at that timing included in the second synchronized data group QG. For example, the statistical difference between the first synchronized data group PG and the second synchronized data group QG may be a difference between the median of the synchronized data at a certain timing in one cycle included in the first synchronized data group PG and the median of the synchronized data at that timing included in the second synchronized data group QG.

Referring to Fig. 3 again, subsequent to the step S6, a snapping symptom of the wire cable 5 is detected when the largest one of the statistical differences between the first and second synchronized data groups obtained for the respective data obtained at the same timing in the one cycle is larger than a predetermined threshold (step S7). That is, the detection means 3 detects a snapping symptom of the wire cable when the largest one (dmax in Fig. 12) of the statistical differences between the first and second synchronized data groups obtained for the respective data obtained at the same timing in the one cycle is larger than a predetermined threshold P.

When the wire cable 5 is relatively long, the statistical difference between the first synchronized data group PG (see Fig. 10) and the second synchronized data group QG (see Fig. 11), which are obtained for respective data obtained at the same timing in the one cycle, is small compared to when the wire cable 5 is relatively short. Further, in general, the smaller the number of broken wires in the wire cable 5 is, the smaller the statistical difference between the first synchronized data group PG and the second synchronized data group QG, which are obtained for respective data obtained at the same timing in the one cycle, becomes. Therefore, in order to detect a snapping symptom of the wire cable 5 even when the wire cable 5 is long and/or the number of broken wires in the wire cable 5 is small, it is necessary to reduce the predetermined threshold P, which is used to determine whether or not there is a snapping symptom of the wire cable 5. Since the effect of a disturbance that changes over a long period of time with respect to the one cycle of bending and expanding of the wire cable 5 and the effect of a sudden disturbance can be reduced in the above-described statistical difference as described above, the predetermined threshold P can be set to a smaller value. As a result, it is possible to detect a snapping symptom of the wire cable 5 more accurately.

Note that the snapping symptom detection apparatus 1 may be configured so that when the detection means 3 detects a snapping symptom of the wire cable, the snapping symptom detection apparatus 1 informs a worker of the snapping symptom of the wire cable by a sound, a video image, or the like.

An example of a method for determining a threshold that is used to determine whether or not there is a snapping symptom of a wire cable is explained hereinafter.

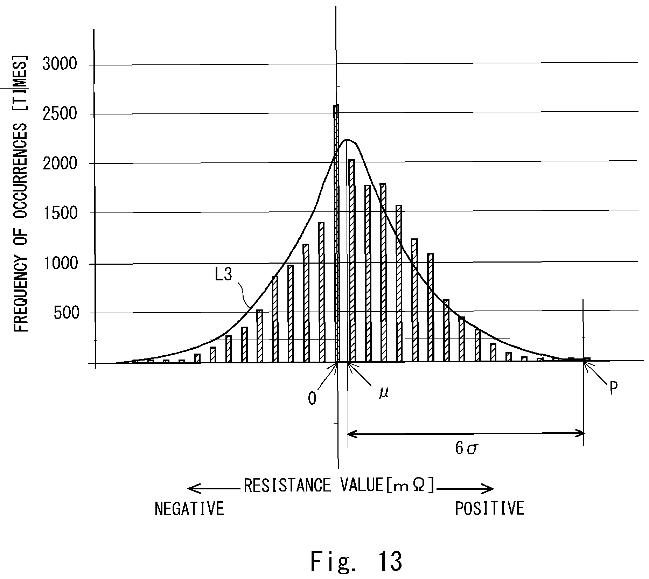

Fig. 13 is a graph showing an example of a distribution of resistance values that are detected in the wire cable 5 that is not snapped and through which an electric current is being carried by the sensor 2 under an environment with small disturbance. Note that the horizontal axis indicates the resistance value of the wire cable 5 detected by the sensor 2 and the vertical axis indicates the frequency of occurrences. As shown in Fig. 13, the distribution of resistance values that are detected in advance in the wire cable 5 that is not snapped and through which an electric current is being carried by the sensor 2 is roughly a normal distribution and hence can be approximated by a normal distribution curve L3. Variations in the resistance value of the wire cable 5 detected by the sensor 2 are caused by measurement errors of the sensor 2.

An average value and a standard deviation in the normal distribution curve L3 are represented by µ and σ, respectively. The probability that the resistance value of the wire cable 5 detected by the sensor 2 falls within a range of (µ±6σ in the normal distribution curve L3 is 99.999999%. That is, the probability that a resistance value detected in the wire cable 5 that is not snapped and through which an electric current is being carried by the sensor 2 under an environment with small disturbance falls outside the range of µ±6σ is extremely small.

As described above, the effect of a disturbance that changes over a long period of time with respect to the one cycle of bending and expanding of the wire cable 5 and the effect of a sudden disturbance can be reduced in the statistical difference between the first synchronized data group PG (see Fig. 10) and the second synchronized data group QG (see Fig. 11) which are obtained for respective data obtained at the same timing in the one cycle. Therefore, the predetermined threshold P, which is used to determine whether or not there is a snapping symptom of the wire cable 5, can be set to a small value comparable to measurement errors, e.g., to a value 6σ, i.e., a value six times the standard deviation σ of the normal distribution curve L3. That is, when the largest one (dmax in Fig. 12) of the statistical differences between the first synchronized data group PG and the second synchronized data group QG obtained for the respective data obtained at the same timing in the one cycle is larger than the value 6σ, it is determined that there is a difference larger than the level of measurement errors between the first synchronized data group PG and the second synchronized data group QG, i.e., a difference that results from a snapping symptom of the wire cable 5. By setting the predetermined threshold P to a small value comparable to measurement errors as described above, it is possible to accurately detect a snapping symptom of the wire cable 5 even when the wire cable 5 is long and/or the number of broken wires in the wire cable 5 is small.

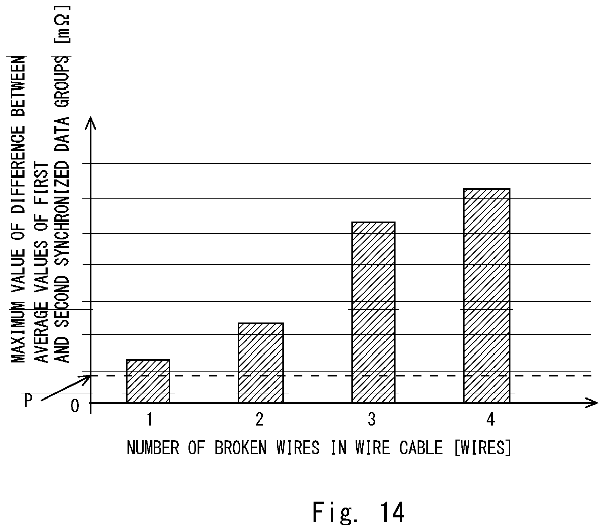

Fig. 14 is a graph showing a relation between the number of broken wires in the wire cable 5 and the maximum value of the difference between the average values of the first synchronized data group PG (see Fig. 10) and the second synchronized data group QG (see Fig. 11) which are obtained for respective data obtained at the same timing in the one cycle. Note that the horizontal axis indicates the number of broken wires in the wire cable 5 [wires] and the vertical axis indicates the maximum value of the difference between the average values of the first synchronized data group PG and the second synchronized data group QG which are obtained for respective data obtained at the same timing in the one cycle. The length of the wire cable 5 used in the verification (i.e., the test) was about 45 cm. The predetermined threshold P was set to a value six times the standard deviation σ of the normal distribution curve L3 shown in Fig. 13 (i.e., a value 6σ). As shown in Fig. 14, as the number of broken wires in the wire cable 5 decreases, the maximum value of the difference between the average values of the first synchronized data group PG and the second synchronized data group QG, which are obtained for respective data obtained at the same timing in the one cycle, decreases. That is, when the number of broken wires in the wire cable 5 is one, the maximum value of the difference between the average values of the first synchronized data group PG and the second synchronized data group QG, which are obtained for respective data obtained at the same timing in the one cycle, is the smallest. By setting the predetermined threshold P as described above, it is possible to determine that there is a snapping symptom in the wire cable 5 even when only one wire in the wire cable 5 is broken.

Note that the present disclosure is not limited to the above-described embodiments, and various modifications can be made without departing from the spirit and scope of the present disclosure. For example, although the recording medium in which the resistance value detected by the sensor 2, the signal indicating the cycle of bending and expanding received from the control apparatus 6, and the like are stored is disposed in the detection means 3 in the above-described embodiment, the recording medium may be disposed in an entity other than the detection means 3. When the recording medium is disposed in an entity other than the detection means 3, the detection means 3 accesses the recording medium when the first data group is generated (see step S1 in Fig. 3) and when the second data group is generated (see step S2 in Fig. 3).

A program can be stored and provided to a computer using any type of non-transitory computer readable media. Non-transitory computer readable media include any type of tangible storage media. Examples of non-transitory computer readable media include magnetic storage media (such as floppy disks, magnetic tapes, hard disk drives, etc.), optical magnetic storage media (e.g. magneto-optical disks), CD-ROM (compact disc read only memory), CD-R (compact disc recordable), CD-R/W (compact disc rewritable), and semiconductor memories (such as mask ROM, PROM (programmable ROM), EPROM (erasable PROM), flash ROM, RAM (random access memory), etc.). The program may be provided to a computer using any type of transitory computer readable media. Examples of transitory computer readable media include electric signals, optical signals, and electromagnetic waves. Transitory computer readable media can provide the program to a computer via a wired communication line (e.g. electric wires, and optical fibers) or a wireless communication line.

From the invention thus described, it will be obvious that the embodiments of the invention may be varied in many ways. Such variations are not to be regarded as a departure from the spirit and scope of the invention, and all such modifications as would be obvious to one skilled in the art are intended for inclusion within the scope of the following claims.

Detection means generates a first data group including a plurality of one-cycle time-series data in a reference period and a second data group including a predetermined number of one-cycle time-series data in an inspection target period, generates, after performing an offset correction for each one-cycle time-series data included in the first and second data groups, a first synchronized data group by sorting out data in the plurality of one-cycle time-series data included in the first data group according to the timing, generates a second synchronized data group by sorting out data in the plurality of one-cycle time-series data included in the second data group according to the timing, and detects a snapping symptom when a largest one of statistical differences between the first and second synchronized data groups at respective timings in the one cycle is larger than a predetermined threshold.

## Claims

1. A wire-cable snapping symptom detection apparatus (1) comprising:
a wire cable (5);
a sensor (2) configured to detect a resistance value in the wire cable (5) through which a current is being carried; and
detection means (3) for detecting a snapping symptom of the wire cable (5) based on the detected resistance value, wherein
the detection means (3):
generates, for the wire cable (5) which is repeatedly bent and expanded, a first data group by extracting a plurality of one-cycle time-series data each corresponding to one cycle of bending and expanding of the wire cable (5) from time-series data detected in a reference period by the sensor (2);
generates a second data group by extracting a predetermined number of one-cycle time-series data each corresponding to the one cycle of bending and expanding of the wire cable (5) from time-series data detected in an inspection target period by the sensor (2), the inspection target period being later than the reference period;
after performing a correction for each one-cycle time-series data included in the first and second data groups so that offsetting is performed and a first value of the one-cycle time-series data is thereby made equal to a predetermined value,
generates a first synchronized data group by sorting out data in the plurality of one-cycle time-series data included in the first data group so that data obtained at the same timing in the one cycle are put together;
generates a second synchronized data group by sorting out data in the plurality of one-cycle time-series data included in the second data group so that data obtained at the same timing in the one cycle are put together;
obtains a statistical difference between the first and second synchronized data groups for respective data obtained at the same timing in the one cycle; and
detects a snapping symptom of the wire cable (5) when a largest one of the statistical differences obtained for the respective data obtained at the same timing in the one cycle is larger than a predetermined threshold.

2. The wire-cable snapping symptom detection apparatus (1) according to Claim 1, wherein the detection means (3) obtains an approximate normal distribution curve for a distribution of the plurality of resistance values detected in advance in the wire cable (5), which is not snapped and through which an electric current is being carried, by the sensor (2), and determines the threshold based on a standard deviation in the obtained normal distribution curve.

3. The wire-cable snapping symptom detection apparatus (1) according to Claim 1 or 2, wherein the statistical difference is a difference between an average value of synchronized data at a certain timing in the one cycle included in the first synchronized data group and an average value of synchronized data at that timing included in the second synchronized data group.
